# EUROPÄISCHE PATENTSCHRIFT

(11) **EP 2 111 650 B1**
(45) Veröffentlichungstag und Bekanntmachung des Hinweises auf die Patenterteilung: **07.03.2018**
(21) Anmeldenummer: 08706791.4
(22) Anmeldetag: 23.01.2008
(51) Int. Cl.: H01L 33/02, H01L 21/285, H01L 33/20, H01L 33/32, H01L 33/36, H01L 33/00

(54) **HALBLEITERCHIP UND VERFAHREN ZUR HERSTELLUNG EINES HALBLEITERCHIPS**
SEMI-CONDUCTOR CHIP AND METHOD FOR PRODUCING A SEMI-CONDUCTOR CHIP
PUCE À SEMI-CONDUCTEUR ET PROCÉDÉ DE FABRICATION D'UNE PUCE À SEMI-CONDUCTEUR

(30) Priorität: 26.01.2007 DE 102007005057; 18.04.2007 DE 102007018307
(43) Veröffentlichungstag der Anmeldung: 28.10.2009
(73) Patentinhaber: OSRAM Opto Semiconductors GmbH, 93055 Regensburg (DE)
(72) Erfinder: EICHLER, Christoph, 93105 Tegernheim (DE); STRAUSS, Uwe, 93077 Bad Abbach (DE); AVRAMESCU, Adrian Stefan, 93051 Regensburg (DE)
(74) Vertreter: Epping - Hermann - Fischer
(86) Internationale Anmeldenummer: PCT/DE2008/000123
(87) Internationale Veröffentlichungsnummer: WO 2008/089739

(56) Entgegenhaltungen:
- EP-A- 1 251 567
- WO-A-99/13499
- US-A1- 2002 179 918
- US-A1- 2003 164 502
- US-A1- 2004 058 465
- US-A1- 2004 119 082
- US-A1- 2005 211 995
- US-A1- 2006 094 138
- US-A1- 2006 138 432
- US-A1- 2006 192 217
- US-B1- 6 287 947
- YOUN D-H ET AL: "INVESTIGATION ON THE P-TYPE ACTIVATION MECHANISM IN MG-DOPED GAN FILMS GROWN BY METALORGANIC CHEMICAL VAPOR DEPOSITION" JAPANESE JOURNAL OF APPLIED PHYSICS, JAPAN SOCIETY OF APPLIED PHYSICS, TOKYO, JP, Bd. 38, Nr. PART 01, 02A, 1. Februar 1999 (1999-02-01), Seiten 631-634, XP000924401 ISSN: 0021-4922

## Beschreibung

Die Erfindung betrifft einen Halbleiterchip, insbesondere einen Halbleiterchip der zur Erzeugung von Strahlung vorgesehen ist, und ein Verfahren zur Herstellung eines Halbleiterchips.

Diese Patentanmeldung beansprucht die Priorität der deutschen Patentanmeldungen 10 2007 005 057.9 und 10 2007 018 307.2.

Strahlungsemittierende Halbleiterchips auf der Basis von Nitrid-Verbindungshalbleitern weisen oftmals eine p-leitende Halbleiterschicht auf, die nur eine geringe Leitfähigkeit besitzt. Die damit einhergehende geringe Querleitfähigkeit einer solchen p-leitenden Halbleiterschicht erschwert zudem eine in lateraler Richtung gleichmäßige Einprägung eines Betriebsstroms in einen zur Erzeugung von Strahlung vorgesehenen aktiven Bereich des Halbleiterchips.

In der Druckschrift EP 1 251 567 A ist ein Verfahren beschrieben, bei dem ein p-Typ GaN-Halbleiter einer Hitzebehandlung in einem Gas mit Sauerstoff ausgesetzt wird.

Die Druckschrift US 2004/0119082 A1 zielt auf einen ausreichend geringen Kontaktwiderstand zu einer p-Typ-Elektrode ab.

Die Druckschrift US 6 287 947 B1 gibt ein Verfahren an, mit dem ein lichtdurchlässiger Kontakt auf p-Typ Galliumnitrid erzielt werden soll.

In der Druckschrift US 2002/179918 A1 wird eine LED angegeben, bei der die p-Typ transparente Kontaktelektrode und die n-Typ transparente Kontaktelektrode aus demselben Material hergestellt sind.

Gemäß der Druckschrift US 2005/0211995 A1 soll ein hocheffizientes Licht emittierendes Element durch Kavitäten in Form von hexagonalen Pyramiden erzielt werden.

In der Druckschrift US 2006/138432 A1 ist ein Nitrid-Halbleiterbauelement angegeben, bei dem eine Halbleiterschicht selektiv in einer texturierten Struktur gewachsen wird.

Es ist eine Aufgabe der vorliegenden Erfindung, einen Halbleiterchip mit einer p-leitenden Halbleiterschicht anzugeben, der verbesserte Eigenschaften, insbesondere hinsichtlich der Leitfähigkeit der p-leitenden Halbleiterschicht und der vereinfachten Herstellbarkeit des Halbleiterchips, aufweist. Weiterhin soll ein Verfahren zur Herstellung eines Halbleiterchips angegeben werden, mit dem ein Halbleiterchip mit hoher Leitfähigkeit der p-leitenden Halbleiterschicht verbessert hergestellt werden kann.

Diese Aufgabe wird durch einen Halbleiterchip gemäß Patentanspruch 1 beziehungsweise durch ein Verfahren gemäß dem Patentanspruch 10 gelöst. Vorteilhafte Ausgestaltungen und Weiterbildungen der Erfindung sind Gegenstand der abhängigen Patentansprüche.

Ein erfindungsgemäßer Halbleiterchip umfasst einen Halbleiterkörper mit einer Halbleiterschichtenfolge, die einen aktiven Bereich und eine p-leitende Halbleiterschicht aufweist. Der aktive Bereich basiert vorzugsweise auf einem Verbindungshalbleiter, insbesondere auf einem Nitrid-Verbindungshalbleiter, einem Phosphid-Verbindungshalbleiter oder einem Arsenid-Verbindungshalbleiter, und ist weiterhin bevorzugt zur Erzeugung von Strahlung vorgesehen. Auf einer dem aktiven Bereich abgewandten Seite der p-leitenden Halbleiterschicht ist ein nichtmetallischer Anschlussbereich angeordnet, der elektrisch leitend mit der p-leitenden Halbleiterschicht verbunden ist. Der nichtmetallische Anschlussbereich ist für Wasserstoff durchlässig ausgebildet.

Bei der Herstellung der Halbleiterschichtenfolge in die p-leitende Halbleiterschicht eingebrachter Wasserstoff kann, insbesondere während eines Aktivierungsschritts, seitens des nichtmetallischen Anschlussbereichs aus der p-leitenden Halbleiterschicht austreten. Die elektrische Leitfähigkeit der p-leitenden Halbleiterschicht, insbesondere die Querleitfähigkeit der p-leitenden Halbleiterschicht, kann so gesteigert werden. Mit Vorteil können im Betrieb des Halbleiterchips Ladungsträger dem aktiven Bereich verbessert über die p-leitende Halbleiterschicht zugeführt werden.

Unter einem nichtmetallischen Anschlussbereich wird im Rahmen der Erfindung eine Schicht oder Schichtenfolge verstanden, wobei die Schicht beziehungsweise die einzelnen Schichten der Schichtenfolge zwar ein Metall enthalten können, aber keine metallischen Eigenschaften aufweisen. Insbesondere kann der nichtmetallische Anschlussbereich auf Halbleitermaterial basieren oder aus Halbleitermaterial bestehen.

Alternativ oder ergänzend kann der nichtmetallische Anschlussbereich ein TCO-Material enthalten.

TCO-Materialien sind transparente leitende Oxide (transparent conductive oxides, kurz "TCO"), in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Der nichtmetallische Anschlussbereich ist bevorzugt mittels eines für im aktiven Bereich erzeugte Strahlung durchlässigen Materials gebildet. Im Betrieb des Halbleiterchips, der vorzugsweise als LED-Halbleiterchip, insbesondere als Lumineszenzdioden-Halbleiterchip, ausgeführt ist, erzeugte Strahlung kann somit durch den nichtmetallischen Anschlussbereich hindurch aus dem Halbleiterchip austreten.

Weiterhin grenzt der nichtmetallische Anschlussbereich bevorzugt unmittelbar an die p-leitende Halbleiterschicht an. Im Betrieb des Halbleiterchips können dadurch Ladungsträger unmittelbar von dem nichtmetallischen Anschlussbereich in die p-leitende Halbleiterschicht injiziert werden.

Der nichtmetallische Anschlussbereich weist eine Halbleiterschicht auf. Diese Halbleiterschicht ist n-dotiert oder undotiert. Der Begriff "undotierte Halbleiterschicht" umfasst auch eine Halbleiterschicht, die eine geringe Restdotierung, etwa aufgrund von Verunreinigungen in der Halbleiterschicht, aufweist. Verglichen mit einer gezielt dotierten Halbleiterschicht weist eine undotierte Halbleiterschicht also eine geringe Dotierkonzentration auf.

Weiterhin enthält die Halbleiterschicht des nichtmetallischen Anschlussbereichs bevorzugt einen Verbindungshalbleiter, besonders bevorzugt einen Nitrid-Verbindungshalbleiter, insbesondere auf der Basis von In_{y}Ga_{1-y}N mit 0 < y ≤ 1, einen Arsenid-Verbindungshalbleiter oder einen Phosphid-Verbindungshalbleiter.

Unter einem Nitrid-Verbindungshalbleiter wird insbesondere ein III/V-Verbindungshalbleiter verstanden, der Stickstoff enthält. Vorzugsweise umfasst ein Nitrid-Verbindungshalbleiter das Material AlₓIn_{y}Ga_{1-x-y}N mit 0 ≤ x ≤ 1, 0 ≤ y ≤ 1 und x + y ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₓIn_{y}Ga_{1-x-y}N-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Entsprechend wird unter einem Phosphid-Verbindungshalbleiter insbesondere ein III/V-Verbindungshalbleiter verstanden, der Phosphor enthält. Ein Phosphid-Verbindungshalbleiter basiert vorzugsweise auf dem Material AlₙInₘGa₁₋ₙ₋ₘP mit 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

In Analogie dazu wird unter einem Arsenid-Verbindungshalbleiter insbesondere ein III/V-Verbindungshalbleiter verstanden, der Arsen enthält. Ein Arsenid-Verbindungshalbleiter basiert vorzugsweise auf dem Material AlₙInₘGa₁₋ₙ₋ₘAs mit 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, As), auch wenn diese teilweise durch geringe Mengen weiterer Stoffe ersetzt sein können.

Die Herstellung einer Verbindungshalbleiterschicht, insbesondere einer Nitrid-Verbindungshalbleiterschicht, einer Arsenid-Verbindungshalbleiterschicht oder einer Phosphid-Verbindungshalbleiterschicht, erfolgt vorzugsweise mittels epitaktischer Abscheidung, etwa mittels MOVPE oder MBE.

In einer bevorzugten Weiterbildung weist der nichtmetallische Anschlussbereich eine weitere Halbleiterschicht auf, die vorzugsweise auf einem Nitrid-Verbindungshalbleiter, etwa GaN, basiert.

Weitergehend kann der nichtmetallische Anschlussbereich eine, vorzugsweise alternierende, Abfolge von Halbleiterschichten aufweisen. Beispielsweise können abwechselnd eine AlₓIn_{y}Ga_{1-x-y}N-Halbleiterschicht mit 0 < y ≤ 1 und 0 ≤ x ≤ 1, vorzugsweise ein In_{y}Ga_{1-y}N-Halbleiterschicht mit 0 < y ≤ 1, und eine GaN-Halbleiterschicht aufeinander abgeschieden sein. Hierbei sind die Halbleiterschichten des nichtmetallischen Anschlussbereichs bevorzugt jeweils n-dotiert oder undotiert ausgeführt.

In einer Ausführungsvariante ist der nichtmetallische Anschlussbereich in den Halbleiterkörper integriert. Der Halbleiterkörper umfasst also den nichtmetallischen Anschlussbereich. Der nichtmetallische Anschlussbereich weist in diesem Fall zumindest eine, n-dotierte oder undotierte, Halbleiterschicht auf, die auf der dem aktiven Bereich abgewandten Seite der p-leitenden Halbleiterschicht angeordnet ist.

In einer alternativen Ausführungsvariante ist der nichtmetallische Anschlussbereich mittels einer auf dem Halbleiterkörper angeordneten Schicht gebildet. Die auf dem Halbleiterkörper angeordnete Schicht ist auf dem vorgefertigten Halbleiterkörper abgeschieden und somit außerhalb des Halbleiterkörpers angeordnet.

In einer bevorzugten Weiterbildung enthält die auf dem Halbleiterkörper angeordnete Schicht des nichtmetallischen Anschlussbereichs ein TCO-Material.
Mittels einer derartigen TCO-Schicht können Ladungsträger im Betrieb des Halbleiterchips auf vereinfachte Weise großflächig in die p-leitende Halbleiterschicht injiziert werden, wobei gleichzeitig eine Absorption von im Halbleiterkörper erzeugter Strahlung in diesem Material vorteilhaft gering ist.

Der nichtmetallische Anschlussbereich weist eine Ausnehmung oder eine Mehrzahl von Ausnehmungen auf. Durch die Ausnehmung beziehungsweise durch die Ausnehmungen kann, insbesondere bei einem Aktivierungsschritt während der Herstellung des Halbleiterchips, Wasserstoff aus der p-leitenden Halbleiterschicht austreten. Durch den Aktivierungsschritt wird die elektrische Leitfähigkeit der p-leitenden Halbleiterschicht dadurch erhöht, dass Wasserstoff, der bei der Herstellung der p-leitenden Halbleiterschicht in diese Halbleiterschicht eingebaut wird, von den Akzeptoren, etwa Mg-Atomen oder anderen Atomen aus der zweiten Hauptgruppe des Periodensystems, in der p-leitenden Halbleiterschicht abgespalten wird. Durch ein Austreten des Wasserstoffs aus der Ausnehmung beziehungsweise aus den Ausnehmungen ist der Aktivierungsschritt verbessert durchführbar. Mit Vorteil ist so eine p-leitende Halbleiterschicht mit verbesserter Leitfähigkeit herstellbar.

Die Ausnehmungen sind derart ausgeführt und relativ zueinander angeordnet, dass Wasserstoff, insbesondere bei der Aktivierung der Akzeptoren in der p-leitenden
Halbleiterschicht, möglichst großflächig aus der p-leitenden Halbleiterschicht austreten kann. Auf diese Weise kann eine p-leitende Halbleiterschicht mit einer vergleichsweise großen Querleitfähigkeit, das heißt einer großen Leitfähigkeit in lateraler Richtung, vereinfacht erzielt werden. Hierbei wird unter der lateralen Richtung eine Richtung verstanden, die senkrecht zu einer Abscheiderichtung der Halbleiterschichtenfolge verläuft.
Die Ausnehmung beziehungsweise zumindest eine der Ausnehmungen erstreckt sich entlang einer Abscheiderichtung der Halbleiterschichtenfolge durch den nichtmetallischen Anschlussbereich hindurch. Mittels der Ausnehmung ist also ein Kanal gebildet, durch den Wasserstoff aus der p-leitenden Halbleiterschicht austreten kann.

In einer Ausführungsvariante ist der nichtmetallische Anschlussbereich zusammenhängend ausgeführt.

In einer alternativen Ausführungsvariante ist der nichtmetallische Anschlussbereich in zumindest zwei voneinander beabstandete Teilbereiche geteilt. Die Teilbereiche des nichtmetallischen Anschlussbereichs sind also inselartig ausgebildet. Insbesondere kann die Trennung des nichtmetallischen Anschlussbereichs mittels der Ausnehmung beziehungsweise zumindest einer der Ausnehmungen erfolgen.

In einer weiteren bevorzugten Ausgestaltung ist der nichtmetallische Anschlussbereich mittels der Ausnehmung beziehungsweise mittels der Ausnehmungen derart ausgebildet, dass die Auskoppeleffizienz einer im aktiven Bereich des Halbleiterchips erzeugten Strahlung gesteigert ist. Die Ausnehmungen in dem nichtmetallischen Anschlussbereich beziehungsweise die inselartigen Bereiche des nichtmetallischen Anschlussbereichs können beispielsweise regelmäßig, etwa matrixartig, angeordnet sein.

Weiterhin kann der nichtmetallische Anschlussbereich mittels der Ausnehmung beziehungsweise mittels der Ausnehmungen zumindest bereichsweise mikrolinsenartig, pyramidenartig oder pyramidenstumpfartig ausgebildet sein.

Die Ausnehmung beziehungsweise die Ausnehmungen können in Aufsicht auf den Halbleiterchip beispielsweise eine runde, elliptische oder mehreckige, etwa rechteckige, Grundform aufweisen.

In einer bevorzugten Weiterbildung ist der nichtmetallische Anschlussbereich mittels der Ausnehmung beziehungsweise der Ausnehmungen gemäß einem photonischen Kristall geformt. Zur Formung des photonischen Kristalls kann der nichtmetallische Anschlussbereich, insbesondere in zwei zueinander senkrechten Richtungen, eine periodische Struktur aufweisen. Eine Periodenlänge der Struktur, also die Länge, nach der sich eine Struktur periodisch wiederholt, liegt bevorzugt im Bereich der Wellenlänge der im aktiven Bereich erzeugten Strahlung im Material des nichtmetallischen Anschlussbereichs. Besonders bevorzugt liegt die Periodenlänge der Struktur im Bereich vom einschließlich 0,1-fachen bis zum einschließlich 10-fachen der Wellenlänge der im aktiven Bereich erzeugten Strahlung im Material des nichtmetallischen Anschlussbereichs. Diese Wellenlänge ergibt sich durch die Wellenlänge der im aktiven Bereich erzeugten Strahlung im Vakuum dividiert durch den Brechungsindex des nichtmetallischen Anschlussbereichs. Im Zweifel wird hierbei unter dem Brechungsindex des nichtmetallischen Anschlussbereichs der entlang der Abscheiderichtung gemittelte Brechungsindex des nichtmetallischen Anschlussbereichs verstanden.

In einer weiteren Ausgestaltung sind die Ausnehmungen des nichtmetallischen Anschlussbereichs unregelmäßig angeordnet. Bevorzugt sind die Ausnehmungen als Nanokanäle ausgebildet. Diese Nanokanäle sind weiterhin bevorzugt in der Halbleiterschicht beziehungsweise in den Halbleiterschichten des nichtmetallischen Anschlussbereichs ausgebildet und können bereits während der Abscheidung der Halbleiterschicht beziehungsweise der Halbleiterschichten entstehen. Eine nachfolgende Strukturierung des nichtmetallischen Anschlussbereichs zur Ausbildung der Ausnehmungen ist mit Vorteil nicht erforderlich.

Weiterhin bevorzugt erstrecken sich die Nanokanäle in Abscheiderichtung der Halbleiterschichtenfolge durch den nichtmetallischen Anschlussbereich hindurch. Die Nanokanäle können beispielsweise eine pyramidenartige oder pyramidenstumpfartige Grundform aufweisen, wobei die Grundfläche der Pyramide vorzugsweise senkrecht zur Abscheiderichtung der Halbleiterschichtenfolge verläuft.

Die Nanokanäle in dem nichtmetallischen Anschlussbereich weisen vorzugsweise eine Flächendichte von einschließlich 10⁶ cm⁻² bis einschließlich 10¹² cm⁻², besonders bevorzugt von einschließlich 10⁸ cm⁻² bis einschließlich 10¹⁰ cm⁻², auf. Bei dieser Ausgestaltung weist der nichtmetallische Anschlussbereich also eine Vielzahl von Ausnehmungen auf, durch die Wasserstoff, insbesondere während des Aktivierungsschritts, aus der p-leitenden Halbleiterschicht austreten kann.

In einer bevorzugten Weiterbildung weisen die Nanokanäle in dem nichtmetallischen Anschlussbereich in lateraler Richtung eine Strukturgröße zwischen einschließlich 1 nm und einschließlich 1 *µ*m, besonders bevorzugt zwischen einschließlich 50 nm und einschließlich 300 nm, auf. Durch diese Nanokanäle kann, insbesondere bei der Aktivierung der Akzeptoren der p-leitenden Halbleiterschicht Wasserstoff aus der p-leitenden Halbleiterschicht und somit aus dem Halbleiterchip durch den nichtmetallischen Anschlussbereich hindurch austreten.

In einer weiteren bevorzugten Ausgestaltung ist auf dem nichtmetallischen Anschlussbereich eine Kontaktschicht angeordnet. Die Kontaktschicht dient insbesondere der externen Kontaktierung des Halbleiterchips und ist zweckmäßigerweise elektrisch leitend, bevorzugt metallisch, ausgeführt. Die Kontaktschicht befindet sich vorzugsweise auf der der p-leitenden Halbleiterschicht abgewandten Seite des nichtmetallischen Anschlussbereichs. Der nichtmetallische Anschlussbereich ist also zumindest bereichsweise zwischen der Kontaktschicht und der p-leitenden Halbleiterschicht angeordnet.

Im Betrieb des Halbleiterchips kann an der Kontaktschicht eine externe elektrische Spannung angelegt werden, so dass Ladungsträger über die Kontaktschicht durch den nichtmetallischen Anschlussbereich in die p-leitende Halbleiterschicht injiziert werden. Nachfolgend können die Ladungsträger von der p-leitenden Halbleiterschicht in den aktiven Bereich injiziert werden und dort unter Emission von Strahlung rekombinieren.

Weiterhin können mittels der Kontaktschicht gegebenenfalls voneinander beabstandete Teilbereiche des nichtmetallischen Anschlussbereichs elektrisch leitend miteinander verbunden sein. Durch die Kontaktschicht kann also eine Bestromung der p-leitenden Halbleiterschicht über verschiedene, voneinander beabstandete, Teilbereiche des nichtmetallischen Anschlussbereichs erfolgen.

In einer weiteren bevorzugten Ausgestaltung weist die p-leitende Halbleiterschicht einen in lateraler Richtung umgrenzten Bereich auf, in dem die p-leitende Halbleiterschicht eine geringere Leitfähigkeit aufweist als außerhalb des lateral umgrenzten Bereichs. Die Leitfähigkeit der p-leitenden Halbleiterschicht ist also in lateraler Richtung gezielt variiert. Auf diese Weise ist die Injektion von Ladungsträger im Betrieb des Halbleiterchips von der p-leitenden Halbleiterschicht in den aktiven Bereich in lateraler Richtung variierbar.

In einer bevorzugten Weiterbildung überlappt der in lateraler Richtung umgrenzte Bereich geringerer Leitfähigkeit in einem Grundriss des Halbleiterchips mit der Kontaktschicht. Im Betrieb des Halbleiterchips werden dadurch Ladungsträger vorwiegend außerhalb des lateral umgrenzten Bereichs von der p-leitenden Halbleiterschicht in den aktiven Bereich injiziert. Eine Absorption vom im aktiven Bereich erzeugter Strahlung durch die Kontaktschicht kann so mit Vorteil vermindert werden.

In einer weiteren bevorzugten Ausgestaltung ist auf dem nichtmetallischen Anschlussbereich eine Leitungsschicht aufgebracht. Die Leitungsschicht ist vorzugsweise für im aktiven Bereich erzeugte Strahlung durchlässig ausgeführt. Besonders bevorzugt enthält die Leitungsschicht ein TCO-Material oder besteht aus einem TCO-Material. Mittels der Leitungsschicht können Ladungsträger im Betrieb des Halbleiterchips vereinfacht in den Anschlussbereich injiziert werden. Insbesondere können voneinander beabstandete Teilbereiche des nichtmetallischen Anschlussbereichs durch die Leitungsschicht elektrisch leitend miteinander verbunden sein.

Die Leitungsschicht ist vorzugsweise zumindest bereichsweise zwischen dem nichtmetallischen Anschlussbereich und der Kontaktschicht angeordnet.

In einer weiteren bevorzugten Ausgestaltung weist der nichtmetallische Anschlussbereich eine Dicke von mindestens 10 nm, bevorzugt mindestens 20 nm, besonders bevorzugt mindestens 100 nm auf. Entsprechend ist also gegebenenfalls die Kontaktschicht um mindestens 10 nm, bevorzugt mindestens 20 nm, besonders bevorzugt mindestens 100 nm, von der p-leitenden Halbleiterschicht beabstandet. Je dicker der nichtmetallische Anschlussbereich ausgeführt ist, desto höher kann die Querleitfähigkeit des nichtmetallischen Anschlussbereichs sein. Eine großflächige Injektion von Ladungsträgern in die p-leitende Halbleiterschicht wird dadurch vereinfacht. Die Dicke des nichtmetallischen Anschlussbereichs, und damit gegebenenfalls der Abstand der Kontaktschicht von der p-leitenden Halbleiterschicht, kann daher auch 200 nm oder mehr, insbesondere auch 500 nm oder mehr, betragen.

Die Dicke des nichtmetallischen Anschlussbereichs kann weiterhin derart ausgeführt sein, dass die Auskoppeleffizienz von im aktiven Bereich erzeugter Strahlung aus dem Halbleiterchip gesteigert ist. Der nichtmetallische Anschlussbereich kann beispielsweise die Funktion einer Entspiegelungsschicht erfüllen. Weiterhin kann der nichtmetallische Anschlussbereich sowohl hinsichtlich seiner lateralen Struktur, die mittels der Ausnehmung beziehungsweise mittels der Ausnehmungen gebildet ist, als auch hinsichtlich der Dicke, also insgesamt in drei Raumrichtungen, für eine effiziente Strahlungsauskopplung geeignet dimensioniert sein.

In einer weiteren bevorzugten Ausgestaltung ist an der dem aktiven Bereich abgewandten Seite der p-leitenden Halbleiterschicht ein Tunnelübergang ausgebildet. Mittels des Tunnelübergangs wird im Betrieb des Halbleiterchips eine Injektion von Ladungsträgern in die p-leitende Halbleiterschicht vereinfacht. Der Tunnelübergang kann beispielsweise mittels einer n-dotierten Halbleiterschicht gebildet werden, die unmittelbar an die p-leitende Halbleiterschicht angrenzt. Insbesondere ist die n-dotierte Halbleiterschicht bevorzugt vergleichsweise hoch dotiert. Weiterhin ist diese n-leitende Halbleiterschicht bevorzugt Teil des nichtmetallischen Anschlussbereichs. In diesem Fall ist der Tunnelübergang also zwischen der p-leitenden Halbleiterschicht und dem nichtmetallischen Anschlussbereich ausgebildet.

In einer weiteren bevorzugten Ausgestaltung umfasst der Halbleiterchip einen Träger, auf dem der Halbleiterkörper angeordnet ist. Der Träger kann mittels des Abscheidesubstrats für die Halbleiterschichtenfolge gebildet sein. Alternativ kann der Träger vom Abscheidesubstrat verschieden sein. In diesem Fall muss der Träger nicht die hohen Anforderungen an ein Abscheidesubstrat für eine epitaktische Abscheidung der Halbleiterschichtenfolge erfüllen. Der Träger kann hinsichtlich anderer, insbesondere mechanischer, thermischer oder optischer, Eigenschaften gewählt werden.

In einer bevorzugten Weiterbildung ist das Abscheidesubstrat für die Halbleiterschichtenfolge gedünnt oder entfernt. Das Dünnen oder Entfernen des Abscheidesubstrats kann vollständig oder zumindest bereichsweise erfolgen. Der Halbleiterchip kann also als Dünnfilm-Halbleiterchip ausgeführt sein.

Ein Dünnfilm-Halbleiterchip, etwa ein Dünnfilm-Leuchtdioden-Chip, kann sich weiterhin im Rahmen der vorliegenden Erfindung durch mindestens eines der folgenden charakteristischen Merkmale auszeichnen:
- an einer zu einem hin gewandten ersten Hauptfläche eines Halbleiterkörpers, der eine Halbleiterschichtenfolge mit einem aktiven Bereich umfasst, insbesondere einer Epitaxieschichtenfolge, ist eine Spiegelschicht aufgebracht oder, etwa als Bragg-Spiegel in der Halbleiterschichtenfolge integriert, ausgebildet, die zumindest einen Teil der in der Halbleiterschichtenfolge erzeugten Strahlung in diese zurückreflektiert;
- die Halbleiterschichtenfolge weist eine Dicke im Bereich von 20µm oder weniger, insbesondere im Bereich von 10 µm auf; und/oder
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, d.h. sie weist ein möglichst ergodisch stochastisches Streuverhalten auf.

Ein Grundprinzip eines Dünnfilm-Leuchtdiodenchips ist beispielsweise in I. Schnitzer et al., Appl. Phys. Lett. 63 (16), 18. Oktober 1993, 2174 - 2176 beschrieben.

Ein Verfahren zur Herstellung eines erfindungsgemäßen Halbleiterchips, der einen Halbleiterkörper mit einer Halbleiterschichtenfolge aufweist, wobei die Halbleiterschichtenfolge einen, vorzugsweise auf einem Nitrid-Verbindungshalbleiter basierenden, aktiven Bereich und eine p-leitende Halbleiterschicht umfasst, umfasst folgende Schritte.

Zunächst wird ein Aufwachssubstrat für die Abscheidung der Halbleiterschichtenfolge bereitgestellt. Auf diesem Abscheidesubstrat wird der aktive Bereich abgeschieden. Weiterhin wird eine Akzeptor-haltige Halbleiterschicht, vorzugsweise auf dem aktiven Bereich, abgeschieden. Auf der Akzeptor-haltigen Halbleiterschicht wird ein nichtmetallischer Anschlussbereich ausgebildet, durch den Gas, insbesondere Wasserstoff, aus der Akzeptor-haltigen Halbleiterschicht austreten kann. Die p-leitende Halbleiterschicht wird mittels Aktivierung von Akzeptoren in der Akzeptor-haltigen Halbleiterschicht hergestellt. Schließlich wird der Halbleiterchip fertig gestellt.

Die Aktivierung der Akzeptoren erfolgt bevorzugt thermisch, also durch Einstellen einer geeigneten Temperatur des aktiven Bereichs während des Aktivierungsschritts, etwa bei einer Temperatur zwischen 600°C und 900°C. Die Aktivierung erfolgt vorzugsweise nach dem Fertigstellen, also nach der Abscheidung und gegebenenfalls nach dem Ausbilden der Ausnehmungen, des nichtmetallischen Anschlussbereichs.

Beim Ausbilden des nichtmetallischen Anschlussbereichs wird zumindest eine Halbleiterschicht abgeschieden.

In einer Ausgestaltung wird nach der Abscheidung der zumindest einen Halbleiterschicht für den nichtmetallischen Anschlussbereich eine Ausnehmung oder eine Mehrzahl von Ausnehmungen in dem nichtmetallischen Anschlussbereich ausgebildet, durch die bei der Aktivierung der Akzeptoren Wasserstoff aus der Akzeptor-haltigen Halbleiterschicht austreten kann. Das Ausbilden der Ausnehmung beziehungsweise der Ausnehmungen kann beispielsweise mittels Ätzens, etwa mittels nasschemischen oder trockenchemischen Ätzens, erfolgen. Dabei wird der nichtmetallische Anschlussbereich vorzugsweise im Bereich der Ausnehmung beziehungsweise der Ausnehmungen in Abscheiderichtung der Halbleiterschichtenfolge vollständig durchätzt. Weitergehend kann das Ausbilden der Ausnehmung beziehungsweise der Ausnehmungen derart fortgesetzt werden, dass auch Material der p-leitenden Halbleiterschicht bereichsweise entfernt wird.

In einer alternativen Ausgestaltung wird die zumindest eine Halbleiterschicht für den nichtmetallischen Anschlussbereich derart abgeschieden, dass in der zumindest einen Halbleiterschicht eine Mehrzahl von Ausnehmungen, vorzugsweise in Form von Nanokanälen, ausgebildet wird, durch die Wasserstoff aus der Akzeptor-haltigen Halbleiterschicht austreten kann. Auf eine nachfolgende Strukturierung des nichtmetallischen Anschlussbereichs kann mit Vorteil verzichtet werden.

In einer weiteren alternativen Ausgestaltung wird die zumindest eine Halbleiterschicht für den nichtmetallischen Anschlussbereich lateral strukturiert auf dem Halbleiterkörper ausgebildet. Hierfür kann die Abscheidung der zumindest einen Halbleiterschicht mittels Überwachsens der vorgefertigten p-leitenden Halbleiterschicht erfolgen. In diesem Fall kann die p-leitende Halbleiterschicht während der Abscheidung der zumindest einen Halbleiterschicht für den nichtmetallischen Anschlussbereich bereichsweise von einer lateral strukturierten Hilfsschicht bedeckt werden. Die zumindest eine Halbleiterschicht wird nachfolgend in einem von der Hilfsschicht freien Bereich der Halbleiterschichtenfolge ausgebildet. Das Überwachsen stellt einen zweiten epitaktischen Abscheideschritt dar, der auf der bereits in einem vorangegangen Abscheideschritt fertig gestellten p-leitenden Halbleiterschicht erfolgt. Nachfolgend kann die Hilfsschicht entfernt werden. Bei dieser Ausgestaltung werden die Ausnehmung beziehungsweise die Ausnehmungen bereits bei der Abscheidung des nichtmetallischen Anschlussbereichs hergestellt. Auf ein nachfolgendes Ausbilden von Ausnehmungen mittels Entfernens, etwa mittels Ätzens, von zuvor abgeschiedenem Material kann mit Vorteil verzichtet werden.

Weitere Merkmale, vorteilhafte Ausgestaltungen und Zweckmäßigkeiten der Erfindung ergeben sich aus der folgenden Beschreibung der Ausführungsbeispiele in Verbindung mit den Figuren.

Es zeigen:
die Figuren 1A und 1B ein erstes Ausführungsbeispiel für einen erfindungsgemäßen Halbleiterchip in schematischer Aufsicht in Figur 1A und schematischer Schnittansicht in Figur 1B,
die Figuren 2A und 2B ein zweites Ausführungsbeispiel für einen erfindungsgemäßen Halbleiterchip in schematischer Aufsicht in Figur 2A und schematischer Schnittansicht in Figur 2B,
die Figuren 3A und 3B ein drittes Ausführungsbeispiel für einen erfindungsgemäßen Halbleiterchip in schematischer Aufsicht in Figur 3A und schematischer Schnittansicht in Figur 3B,
die Figuren 4A und 4B ein viertes Ausführungsbeispiel für einen erfindungsgemäßen Halbleiterchip in schematischer Aufsicht in Figur 4A und schematischer Schnittansicht in Figur 4B,
die Figuren 5A und 5B ein fünftes Ausführungsbeispiel für einen erfindungsgemäßen Halbleiterchip in schematischer Aufsicht in Figur 5A und schematischer Schnittansicht in Figur 5B,
die Figuren 6A und 6B ein sechstes Ausführungsbeispiel für einen erfindungsgemäßen Halbleiterchip in schematischer Aufsicht in Figur 6A und schematischer Schnittansicht in Figur 6B,
die Figuren 7A und 7B ein siebtes Ausführungsbeispiel für einen erfindungsgemäßen Halbleiterchip in schematischer Aufsicht in Figur 7A und schematischer Schnittansicht in Figur 7B,
die Figuren 8A und 8B ein achtes Ausführungsbeispiel für einen erfindungsgemäßen Halbleiterchip in schematischer Aufsicht in Figur 8A und schematischer Schnittansicht in Figur 8B,
die Figuren 9A und 9B ein neuntes Ausführungsbeispiel für einen erfindungsgemäßen Halbleiterchip in schematischer Aufsicht in Figur 9A und schematischer Schnittansicht in Figur 9B,
die Figuren 10A und 10B ein zehntes Ausführungsbeispiel für einen erfindungsgemäßen Halbleiterchip in schematischer Aufsicht in Figur 10A und schematischer Schnittansicht in Figur 10B,
Figur 11 ein elftes Ausführungsbeispiel für einen erfindungsgemäßen Halbleiterchip in schematischer Schnittansicht,
Figur 12 ein zwölftes Ausführungsbeispiel für einen erfindungsgemäßen Halbleiterchip in schematischer Schnittansicht,
Figur 13 ein dreizehntes Ausführungsbeispiel für einen erfindungsgemäßen Halbleiterchip in schematischer Schnittansicht,
die Figuren 14A bis 14C ein erstes Ausführungsbeispiel für ein erfindungsgemäßes Verfahren anhand von schematisch in Schnittansicht dargestellten Zwischenschritten,
die Figuren 15A bis 15D ein erstes Ausführungsbeispiel für ein erfindungsgemäßes Verfahren anhand von schematisch in Schnittansicht dargestellten Zwischenschritten,
die Figuren 16A bis 16C ein erstes Ausführungsbeispiel für ein erfindungsgemäßes Verfahren anhand von schematisch in Schnittansicht dargestellten Zwischenschritten.

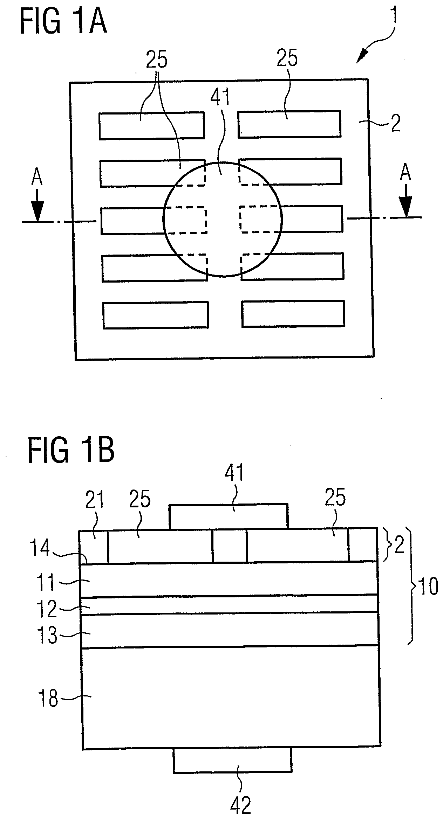

Gleiche, gleichartige und gleich wirkende Elemente sind in den Figuren mit gleichem Bezugszeichen versehen. In den Figuren 1A und 1B ist schematisch ein erstes Ausführungsbeispiel für einen erfindungsgemäßen Halbleiterchip gezeigt. Hierbei stellt die Figur 1B eine Schnittansicht durch den in Figur 1A gezeigten Halbleiterchip 1 entlang der Linie A-A dar.

Der Halbleiterchip 1 umfasst einen Halbleiterkörper mit einer Halbleiterschichtenfolge 10. Die Halbleiterschichtenfolge umfasst einen aktiven Bereich 12, eine p-leitende Halbleiterschicht 11 und eine n-leitende Halbleiterschicht 13. Der aktive Bereich ist also zwischen der p-leitenden Halbleiterschicht und der n-leitenden Halbleiterschicht angeordnet.

Auf der dem aktiven Bereich 12 abgewandten Seite der p-leitenden Halbleiterschicht ist ein nichtmetallischer Anschlussbereich 2 angeordnet. Dieser nichtmetallische Anschlussbereich ist mittels einer Halbleiterschicht 21 gebildet. Der nichtmetallische Anschlussbereich ist also in den Halbleiterkörper 10 integriert.

Die Halbleiterschicht 21 des nichtmetallischen Anschlussbereichs 2 ist n-dotiert. Zwischen dem p-leitenden Bereich 11 und dem nichtmetallischen Anschlussbereich 2 ist also ein Tunnelübergang 14 ausgebildet. Über einen solchen Tunnelübergang können Ladungsträger im Betrieb des Halbleiterchips vereinfacht in die p-leitende Halbleiterschicht injiziert werden.

Der nichtmetallische Anschlussbereich weist bevorzugt eine Dicke, das heißt eine Ausdehnung entlang der Abscheiderichtung der Halbleiterschichtenfolge, von mindestens 10 nm, bevorzugt mindestens 20 nm, besonders bevorzugt mindestens 100 nm auf. Je dicker der nichtmetallische Anschlussbereich ist, desto größer kann die Querleitfähigkeit des nichtmetallischen Anschlussbereichs sein.

Der nichtmetallische Anschlussbereich 2 ist zusammenhängend ausgeführt und weist eine Mehrzahl von Ausnehmungen 25 auf, die in Form einer Matrix, also regelmäßig, angeordnet sind. Entlang einer Abscheiderichtung, also senkrecht zu einer Haupterstreckungsrichtung der Halbleiterschichten der Halbleiterschichtenfolge 10, erstrecken sich die Ausnehmungen 25 vollständig durch den nichtmetallischen Anschlussbereich hindurch. Mittels der Ausnehmungen 25 sind also Kanäle gebildet, durch die Wasserstoff, insbesondere während der Aktivierung der Akzeptoren in der p-leitenden Halbleiterschicht, aus dem Halbleiterkörper, insbesondere aus der p-leitenden Halbleiterschicht, austreten kann.

Die Ausnehmungen weisen in Aufsicht auf den Halbleiterchip eine rechteckige Grundform auf. Davon abweichend können die Ausnehmungen auch eine andere mehreckige Grundform oder eine Form mit zumindest bereichsweise gekrümmten Begrenzungsflächen aufweisen.

Auf der der p-leitenden Halbleiterschicht abgewandten Seite des nichtmetallischen Anschlussbereichs 2 ist eine erste Kontaktschicht 41 ausgebildet. Eine weitere Kontaktschicht 42 ist auf der dem aktiven Bereich 12 abgewandten Seite des Trägers 18 ausgebildet.

Im Betrieb des Halbleiterchips 1, der als Lumineszenzdioden-Chip ausgeführt ist und zur Erzeugung von inkohärenter Strahlung vorgesehen ist, können durch ein Anlegen einer externen elektrischen Spannung zwischen der ersten Kontaktschicht 41 und der zweiten Kontaktschicht 42 Ladungsträger in den Halbleiterkörper injiziert werden und in dem aktiven Bereich 12 unter Emission von Strahlung rekombinieren.

Die Kontaktschicht 41 und die Kontaktschicht 42 sind elektrisch leitend, bevorzugt metallisch, ausgeführt. Bevorzugt enthält die erste Kontaktschicht 41 und/oder die zweite Kontaktschicht 42 ein Metall, beispielsweise Au, Pt, Cu, Al, Ni oder Ti, oder eine metallische Legierung, die zumindest eines der genannten Metalle enthält.

Der Träger 18 ist zweckmäßigerweise elektrisch leitfähig ausgebildet. Beispielsweise kann der Träger mittels eines Abscheidesubstrats für die Halbleiterschichtenfolge 10 gebildet sein. Das Abscheidesubstrat kann beispielsweise Saphir oder SiC enthalten. Das Abscheidesubstrat ist vorzugsweise geeignet, insbesondere n-leitend, dotiert.

Davon abweichend kann der Träger 18 auch vom Abscheidesubstrat für die Halbleiterschichtenfolge 10 verschieden sein. In diesem Fall muss der Träger nicht die hohen Anforderungen, die beispielsweise an die kristallinen Eigenschaften eines Abscheidesubstrats bei einer epitaktischen Abscheidung der Halbleiterschichtenfolge gestellt werden, erfüllen. Vielmehr kann der Träger hinsichtlich anderer Eigenschaften, wie beispielsweise thermischer, mechanischer und/oder optischer Eigenschaften gewählt werden. Der Halbleiterchip kann also als Dünnfilm-Halbleiterchip ausgeführt sein, bei dem das Abscheidesubstrat zumindest bereichsweise entfernt oder gedünnt ist. Der Halbleiterchip kann beispielsweise mittels Wafer-Bondens an dem vom Abscheidesubstrat verschiedenen Träger 18 befestigt sein.

Die p-leitende Halbleiterschicht 11 ist bevorzugt mit Mg dotiert. Bei einer epitaktischen Abscheidung der p-leitenden Halbleiterschicht 11, beispielsweise mittels MOCVD, wird das Magnesium in einem Komplex mit Wasserstoff eingebaut und ist elektrisch nicht aktiv, das heißt das eingebaute Mg wirkt nicht als elektrisch aktiver Akzeptor. Eine Aktivierung der Akzeptoren kann mittels thermischer Aktivierung, also etwa durch Erhitzen des Halbleiterkörpers 10, erfolgen. Dadurch frei werdender Wasserstoff kann durch die Ausnehmungen 25 aus der p-leitenden Halbleiterschicht austreten. Aufgrund des für Wasserstoff durchlässig ausgeführten Anschlussbereichs 2 kann also Wasserstoff bei der Aktivierung seitens des nichtmetallischen Anschlussbereichs aus der p-leitenden Halbleiterschicht und somit aus dem Halbleiterchip austreten.

Die Ausnehmungen 25 sind bevorzugt derart ausgeführt, dass Wasserstoff in lateraler Richtung vergleichsweise gleichmäßig aus der p-leitenden Halbleiterschicht 11 austreten kann. Die p-leitende Halbleiterschicht kann also in lateraler Richtung durchgängig eine vergleichsweise hohe Leitfähigkeit aufweisen. Eine Injektion von Ladungsträgern über die p-leitende Halbleiterschicht 11 in den aktiven Bereich 12 kann dadurch vereinfacht werden.

Der Halbleiterkörper basiert bevorzugt auf dem Verbindungshalbleiter Galliumnitrid. Insbesondere basiert der aktive Bereich bevorzugt auf AlₓIn_{y}Ga_{1-x-y}N mit 0 ≤ x ≤ 1, 0 ≤ y ≤ 1 und x + y ≤ 1.

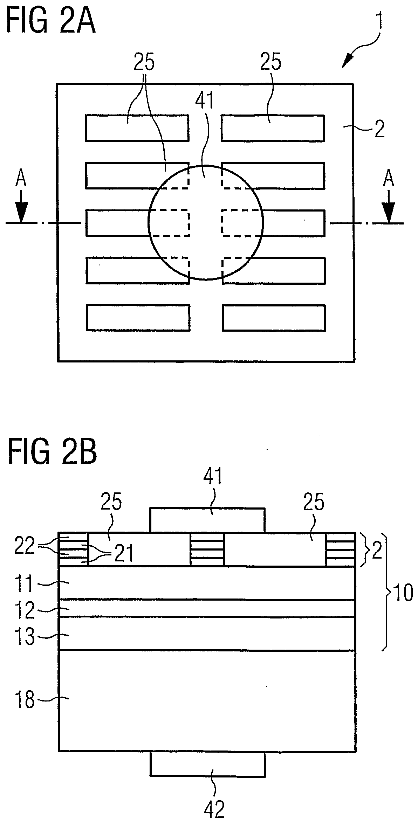

Ein zweites Ausführungsbeispiel für einen erfindungsgemäßen Halbleiterchip ist in den Figuren 2A (Aufsicht) und 2B (Schnittansicht) schematisch dargestellt. Dieses zweite Ausführungsbeispiel entspricht im Wesentlichen dem im Zusammenhang mit Figur 1 beschriebenen ersten Ausführungsbeispiel.

Im Unterschied zum ersten Ausführungsbeispiel weist der nichtmetallische Anschlussbereich 2 eine Mehrzahl von Halbleiterschichten auf. Hierbei ist lediglich beispielhaft ein Fall gezeigt, bei dem eine erste Halbleiterschicht 21 und eine weitere Halbleiterschicht 22 in alternierender Abfolge aufeinander abgeschieden sind. Selbstverständlich kann hierbei die Zahl der Halbleiterschichten von 4 abweichend sein. Die Halbleiterschicht 21 und/oder die weitere Halbleiterschicht 22 basiert bevorzugt auf In_{y}Ga_{1-y}N mit
0 ≤ y ≤ 1. Hierbei können die Halbleiterschicht 21 und die weitere Halbleiterschicht 22 hinsichtlich des In-Gehalts y und/oder hinsichtlich der Dotierung unterschiedlich ausgebildet sein. Insbesondere kann die Halbleiterschicht 21 und/oder die Halbleiterschicht frei von In, also mit y=0, ausgebildet sein. Die Halbleiterschicht 21 und/oder die weitere Halbleiterschicht 22 ist n-dotiert oder undotiert ausgeführt.

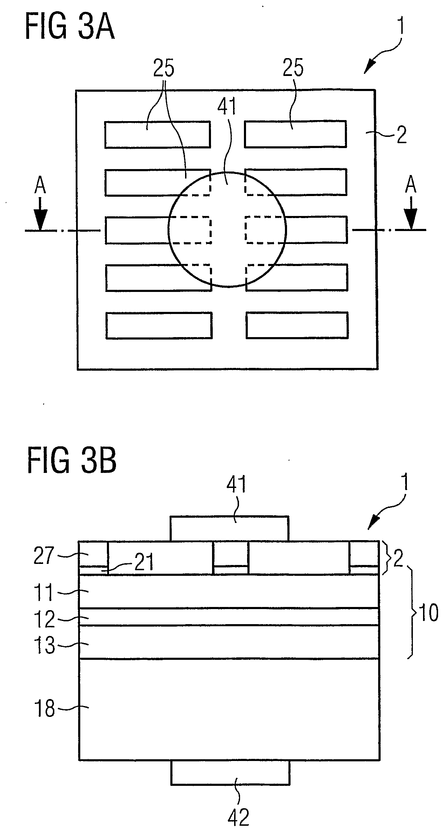

Ein drittes Ausführungsbeispiel für einen erfindungsgemäßen Halbleiterchip ist in den Figuren 3A in Aufsicht und 3B in Schnittansicht schematisch dargestellt. Das dritte Ausführungsbeispiel entspricht im Wesentlichen dem ersten Ausführungsbeispiel.

Im Unterschied zum ersten Ausführungsbeispiel weist der nichtmetallische Anschlussbereich eine Halbleiterschicht 21 und eine Schicht 27, die auf dem Halbleiterkörper 10 angeordnet ist, auf. Die auf dem Halbleiterkörper angeordnete Schicht 27 ist auf der dem aktiven Bereich 12 abgewandten Seite der p-leitenden Halbleiterschicht 11 angeordnet. Die auf dem Halbleiterkörper angeordnete Schicht 27 ist elektrisch leitfähig ausgeführt und enthält bevorzugt ein TCO-Material oder besteht aus einem TCO-Material, beispielsweise Zinkoxid, Zinnoxid, Cadmiumoxid, Titanoxid, Indiumoxid oder Indiumzinnoxid (ITO). Auch ein ternäres TCO-Material kann Anwendung finden.

Von dem in Figur 3B gezeigten dritten Ausführungsbeispiel abweichend kann in dem nichtmetallischen Anschlussbereich 2 auch auf die Halbleiterschicht 21 verzichtet werden. In diesem Fall ist der nichtmetallische Anschlussbereich also vollständig außerhalb des Halbleiterkörpers 10 angeordnet.

Die auf dem Halbleiterkörper angeordnete Schicht 27 ist auf dem vorgefertigten Halbleiterkörper 10 abgeschieden, beispielsweise mittels eines PVD- oder eines CVD-Verfahrens. Insbesondere kann die auf dem Halbleiterkörper angeordnete Schicht aufgesputtert oder aufgedampft werden.

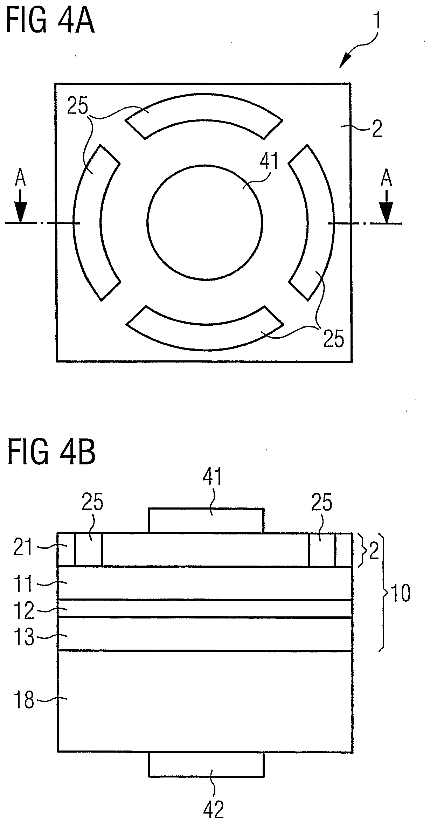

Ein viertes Ausführungsbeispiel für einen erfindungsgemäßen Halbleiterchip ist in den Figuren 4A und 4B schematisch in Aufsicht beziehungsweise in Schnittansicht dargestellt. Hierbei entspricht das vierte Ausführungsbeispiel im Wesentlichen dem ersten Ausführungsbeispiel.

Im Unterschied zum ersten Ausführungsbeispiel weisen die Ausnehmungen 25 in dem nichtmetallischen Anschlussbereich 2 zumindest bereichsweise gekrümmte Umrandungen auf. Hierbei sind die Ausnehmungen gemäß Teilbereichen eines Ringes ausgeführt. Diese ringsegmentartigen Ausnehmungen 25 sind voneinander beabstandet ausgeführt. Auch in diesem Fall ist also der nichtmetallische Anschlussbereich 2 zusammenhängend. Im Betrieb des Halbleiterchips über die Kontaktschicht 41 injizierte Ladungsträger können also in dem gesamten Bereich, in dem der nichtmetallische Anschlussbereich die p-leitende Halbleiterschicht 11 bedeckt, in die p-leitende Halbleiterschicht injiziert werden.

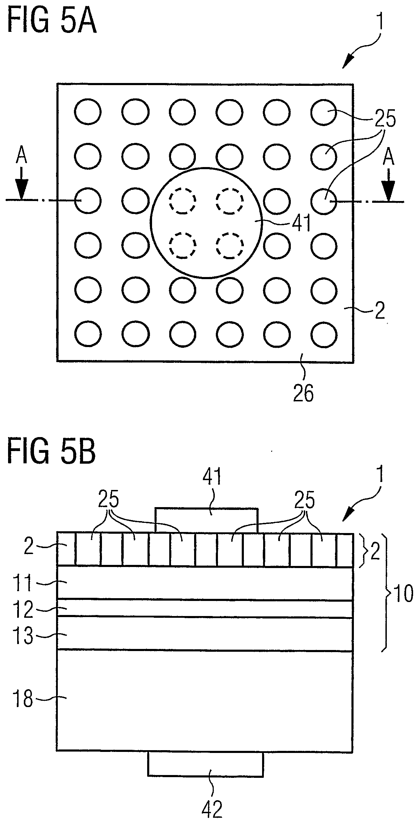

Ein fünftes Ausführungsbeispiel für einen erfindungsgemäßen Halbleiterchip ist in den Figuren 5A und 5B schematisch dargestellt. Im Unterschied zum ersten Ausführungsbeispiel sind die Ausnehmungen 25 in dem nichtmetallischen Anschlussbereich 2 gemäß einem photonischen Kristall 26 geformt. Die Ausnehmungen 25 sind entlang zweier, zueinander senkrecht stehender, Achsen in periodischer Reihenfolge angeordnet. Die Periodenlänge, also die Länge, nach der sich die Struktur des nichtmetallischen Anschlussbereichs 2 wiederholt, liegt bevorzugt in der Größenordnung der Wellenlänge der im aktiven Bereich 12 erzeugten Strahlung. Besonders bevorzugt liegt die Periodenlänge der Struktur im Bereich vom einschließlich 0,1-fachen bis zum einschließlich 10-fachen der Wellenlänge der im aktiven Bereich erzeugten Strahlung im Material des nichtmetallischen Anschlussbereichs.

Die Ausnehmungen sind beispielhaft rund ausgeführt. Selbstverständlich sind auch andere Formen, beispielsweise Formen der Ausnehmungen mit mehreckiger Grundform oder Ausnehmungen mit zumindest bereichsweise gekrümmter Umrandung, geeignet.

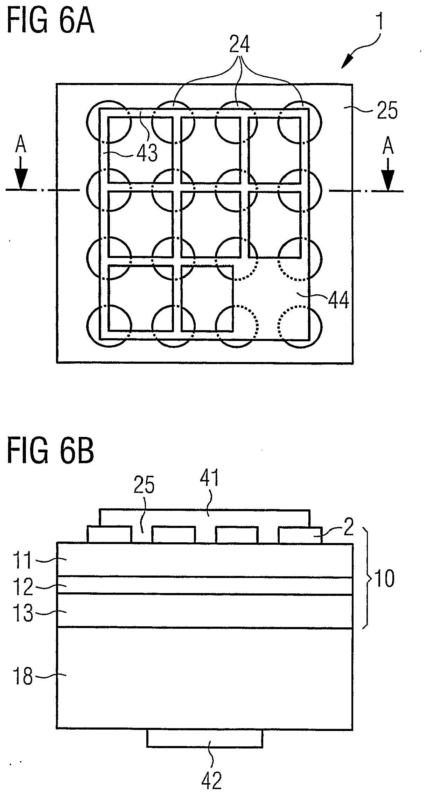

Die Figuren 6A und 6B zeigen ein sechstes Ausführungsbeispiel für einen erfindungsgemäßen Halbleiterchip schematisch in Aufsicht beziehungsweise in Schnittansicht. Das sechste Ausführungsbeispiel entspricht im Wesentlichen dem ersten Ausführungsbeispiel.

Im Unterschied zum ersten Ausführungsbeispiel weist der nichtmetallische Anschlussbereich 2 eine Mehrzahl von Teilbereichen 24 auf, die mittels der Ausnehmung 25 vollständig voneinander getrennt sind. Die Teilbereiche 24 sind in lateraler Richtung voneinander beabstandet.

Die Teilbereiche 24 des nichtmetallischen Anschlussbereichs sind beispielhaft matrixartig angeordnet. Eine hiervon abweichende Anordnung, insbesondere auch eine unregelmäßige Anordnung der Teilbereiche, ist ebenfalls denkbar.

Auf dem nichtmetallischen Anschlussbereich 2 ist wiederum eine Kontaktschicht 41 angeordnet. Im Unterschied zum ersten Ausführungsbeispiel weist die Kontaktschicht 41 einen Kontaktbereich 44 und stegartige Teilbereiche 43 auf. Mittels der Kontaktschicht 41, insbesondere mittels der stegartigen Teilbereiche 43 der Kontaktschicht 41, sind die Teilbereiche 24 des nichtmetallischen Anschlussbereichs 2 elektrisch leitend miteinander verbunden. Im Betrieb des Halbleiterchips werden bei diesem Ausführungsbeispiel Ladungsträger also über voneinander beabstandete Teilbereiche 24 des nichtmetallischen Anschlussbereichs 2 in die p-leitende Halbleiterschicht 11 injiziert.

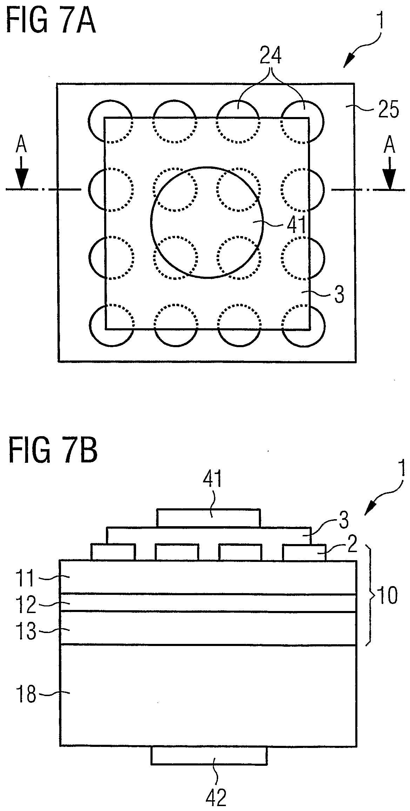

Ein siebtes Ausführungsbeispiel für einen erfindungsgemäßen Halbleiterchip ist in den Figuren 7A und 7B schematisch dargestellt. Das siebte Ausführungsbeispiel entspricht im Wesentlichen dem sechsten Ausführungsbeispiel. Insbesondere weist der nichtmetallische Anschlussbereich 2 wiederum eine Mehrzahl von voneinander beabstandeten Teilbereichen 24 auf.

Im Unterschied zum sechsten Ausführungsbeispiel ist beim siebten Ausführungsbeispiel zwischen dem nichtmetallischen Anschlussbereich 2 und der Kontaktschicht 41 eine Leitungsschicht 3 angeordnet. Die Leitungsschicht 3 ist elektrisch leitfähig ausgeführt und bevorzugt für im aktiven Bereich 12 erzeugte Strahlung transparent oder transluzent ausgebildet. Bevorzugt enthält die Leitungsschicht ein TCO-Material oder besteht aus einem TCO-Material, beispielsweise Zinkoxid, Zinnoxid, Cadmiumoxid, Titanoxid, Indiumoxid oder Indiumzinnoxid (ITO). Auch ein ternäres TCO-Material kann Anwendung finden.

Im Betrieb des Halbleiterchips 1 in die Kontaktschicht 41 injizierte Ladungsträger können mittels der Leitungsschicht 3 den voneinander beabstandeten Teilbereichen 24 des nichtmetallischen Anschlussbereichs 2 zugeführt werden. Die Leitungsschicht 3 kann die p-leitende Halbleiterschicht 11 vollständig oder nur bereichsweise bedecken. Bevorzugt ist die Leitungsschicht in lateraler Richtung derart ausgeführt, dass alle zur Injektion von Ladungsträgern vorgesehenen Teilbereiche 24 des nichtmetallischen Anschlussbereichs 2 mittels der Leitungsschicht 3 elektrisch miteinander verbunden sind. Eine in lateraler Richtung möglichst gleichmäßige Injektion von Ladungsträgern in die p-leitende Halbleiterschicht 11 kann so mit Vorteil erleichtert werden.

Vom in Figur 7A gezeigten siebten Ausführungsbeispiel abweichend kann die Leitungsschicht 3 den Halbleiterkörper 10 beispielsweise auch gitterartig bedecken, wobei die Teilbereiche 24 des nichtmetallischen Anschlussbereichs 2 mittels des Gitters elektrisch leitend miteinander verbunden sind. Auch eine vollständige Bedeckung des nichtmetallischen Anschlussbereichs durch die Leitungsschicht ist möglich.

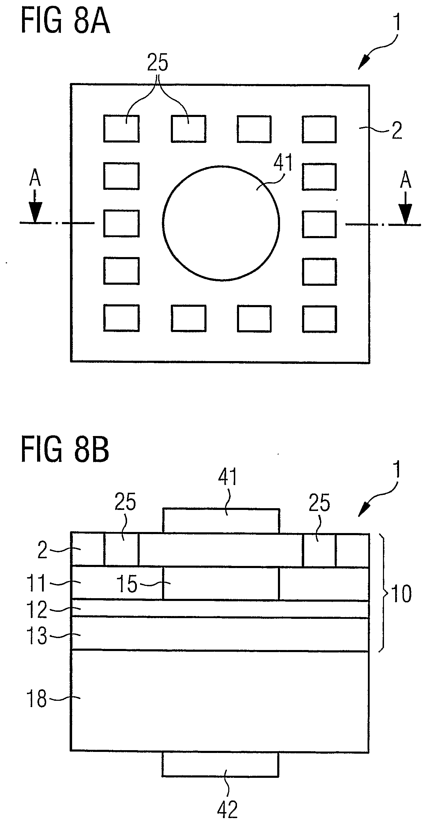

Ein achtes Ausführungsbeispiel für einen erfindungsgemäßen Halbleiterchip ist in den Figuren 8A und 8B schematisch dargestellt. Das achte Ausführungsbeispiel entspricht im Wesentlichen dem ersten Ausführungsbeispiel. Im Unterschied zum ersten Ausführungsbeispiel ist der nichtmetallische Anschlussbereich 2 in einem Bereich, in dem der nichtmetallische Anschlussbereich von der Kontaktschicht 41 bedeckt ist, frei von Ausnehmungen 25. Der nichtmetallische Anschlussbereich 2 weist also in lateraler Richtung nur in einem Bereich Ausnehmungen 25 auf, in dem der nichtmetallische Anschlussbereich auf der der p-leitenden Halbleiterschicht 11 abgewandten Seite von der Kontaktschicht 41 frei ist.

Bei einer Aktivierung der Akzeptoren der p-leitenden Halbleiterschicht 11 während der Herstellung des Halbleiterchips 1 wird ein Austreten von Wasserstoff in einem lateral umgrenzten Bereich 15 der p-leitenden Halbleiterschicht 11, der in einem Grundriss des Halbleiterchips 1 mit der Kontaktschicht 41 überlappt, aufgrund der in diesem lateral umgrenzten Bereich 15 fehlenden Ausnehmungen erschwert. Dies führt zu einer geringeren Leitfähigkeit der p-leitenden Halbleiterschicht in diesem Bereich 15. In dem Teilbereich 15, in dem die Leitfähigkeit geringer ist als außerhalb des Teilbereichs 15, werden folglich weniger Ladungsträger über die p-leitende Halbleiterschicht 11 in den aktiven Bereich 12 injiziert. Dies hat zur Folge, dass im aktiven Bereich 12 unterhalb dieses in lateraler Richtung umgrenzten Bereichs 15 der p-leitenden Halbleiterschicht, und damit unterhalb der Kontaktschicht 41, vergleichsweise wenig Strahlung erzeugt wird. Dadurch wird Strahlung im aktiven Bereich verstärkt dort erzeugt, wo die Strahlung vereinfacht aus dem Halbleiterchip 1 austreten kann. Die Leitfähigkeit der p-leitenden Halbleiterschicht 11 ist in lateraler Richtung also gezielt derart variiert, dass die Auskoppeleffizienz der im aktiven Bereich erzeugten Strahlung gesteigert ist. Bei gleich bleibender im aktiven Bereich erzeugter Strahlungsleistung kann so die aus dem Halbleiterchip 1 austretende Strahlungsleistung mit Vorteil gesteigert werden.

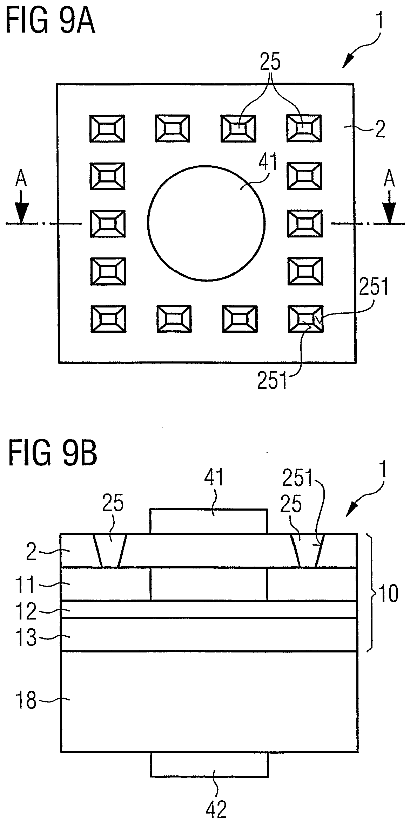

Ein neuntes Ausführungsbeispiel für einen erfindungsgemäßen Halbleiterchip ist in den Figuren 9A (Aufsicht) und 9B (Schnittansicht) schematisch gezeigt. Dieses neunte Ausführungsbeispiel entspricht im Wesentlichen dem achten Ausführungsbeispiel. Im Unterschied zum achten Ausführungsbeispiel weisen die Ausnehmungen 25 schräg zur Abscheiderichtung der Halbleiterschichtenfolge 10 verlaufende Seitenflächen 251 auf.

Insbesondere mittels dieser schräg verlaufenden Seitenflächen 251 kann der nichtmetallische Anschlussbereich 2 mit Vorteil derart ausgebildet sein, dass die Auskoppeleffizienz der im aktiven Bereich des Halbleiterchips erzeugten Strahlung gesteigert ist. In dem gezeigten Ausführungsbeispiel sind die Ausnehmungen beispielhaft pyramidenstumpfartig ausgeführt, wobei die Grundfläche der Pyramide rechteckig ausgeführt ist. Davon abweichend sind auch andere mehreckige Grundformen geeignet. Ebenso können die Ausnehmungen beispielsweise kegelartig oder kegelstumpfartig ausgebildet sein.

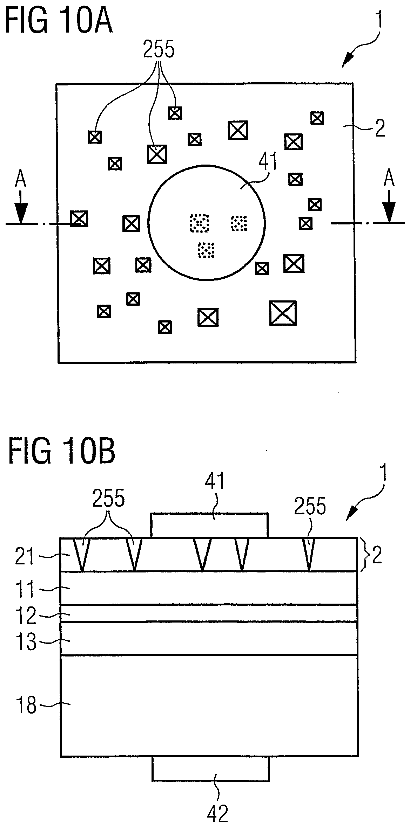

Ein zehntes Ausführungsbeispiel für einen erfindungsgemäßen Halbleiterchip ist in den Figuren 10A und 10B schematisch dargestellt. Das zehnte Ausführungsbeispiel entspricht im Wesentlichen dem ersten Ausführungsbeispiel.

Im Unterschied zum ersten Ausführungsbeispiel ist der nichtmetallische Anschlussbereich 2 mittels einer Halbleiterschicht gebildet, die eine Mehrzahl von unregelmäßig angeordneten Ausnehmungen aufweist. Die Ausnehmungen sind als Nanokanäle 255 ausgebildet und weisen eine pyramidenartige oder pyramidenstumpfartige Grundform auf. Im Unterschied zum ersten Ausführungsbeispiel sind die Ausnehmungen im zehnten Ausführungsbeispiel bereits während der Abscheidung des nichtmetallischen Anschlussbereichs 2 ausgebildet. Die Abscheideparameter während der Herstellung der Halbleiterschicht sind also so gewählt, dass eine Halbleiterschicht mit Ausnehmungen entsteht. Wie im Zusammenhang mit Figur 2 beschrieben, kann der nichtmetallische Anschlussbereich auch eine Mehrzahl von Halbleiterschichten aufweisen, wobei sich die Nanokanäle vorzugsweise vollständig durch die Mehrzahl von Halbleiterschichten hindurch erstrecken.

Die Nanokanäle 255 des nichtmetallischen Anschlussbereichs weisen bevorzugt eine Flächendichte von einschließlich 10⁶ cm⁻² bis einschließlich 10¹² cm⁻², besonders bevorzugt von einschließlich 10⁸ cm⁻² bis einschließlich 10¹⁰ cm⁻², auf. In lateraler Richtung weisen die Nanokanäle bevorzugt eine Strukturgröße zwischen einschließlich 1 nm und einschließlich 1 *µ*m, besonders bevorzugt zwischen einschließlich 50 nm und einschließlich 300 nm auf.

Bei diesem Ausführungsbeispiel weist der nichtmetallische Anschlussbereich also eine überaus hohe Dichte von Ausnehmungen auf, sodass bei der Herstellung des Halbleiterchips während der Aktivierung der Akzeptoren in der p-leitenden Halbleiterschicht 11 Wasserstoff besonders gleichmäßig aus der p-leitenden Halbleiterschicht austreten kann. Eine in lateraler Richtung besonders gleichmäßige Aktivierung der Akzeptoren kann so mit Vorteil erzielt werden.

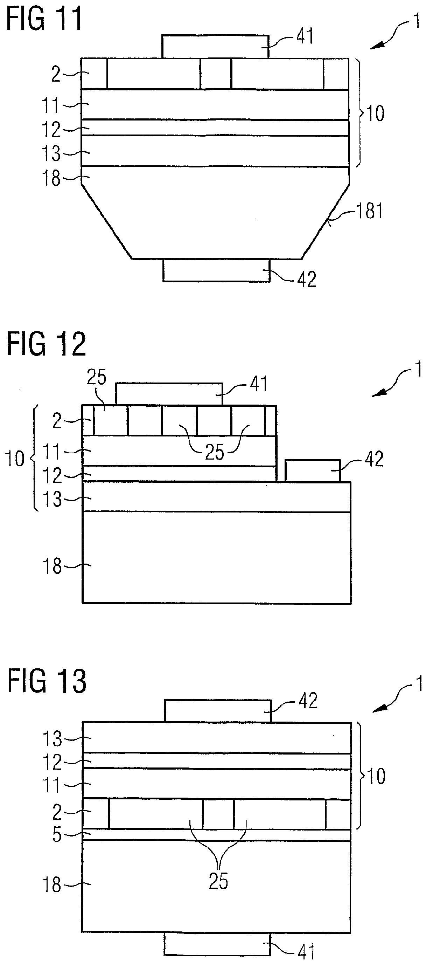

Ein elftes Ausführungsbeispiel für einen erfindungsgemäßen Halbleiterchip ist in Figur 11 anhand einer schematischen Schnittansicht gezeigt. Der Halbleiterchip gemäß dem elften Ausführungsbeispiel entspricht im Wesentlichen dem ersten Ausführungsbeispiel.

Im Unterschied zum ersten Ausführungsbeispiel weist der Träger 18 Seitenflächen 181 auf, die den Träger in lateraler Richtung begrenzen und die zumindest bereichsweise schräg zu der Abscheiderichtung der Halbleiterschichtenfolge 10 verlaufen. Mit zunehmender Entfernung zum Halbleiterkörper 10 verjüngt sich der Träger 18. Diese schräg stehenden Seitenflächen ermöglichen eine gesteigerte Auskopplung der im aktiven Bereich erzeugten Strahlung 12 aus dem Halbleiterchip 1. Insbesondere kann eine Wellenführung von in den Träger 18 eingekoppelter Strahlung innerhalb des Trägers mit Vorteil vermieden werden. Selbstverständlich sind derartige schräge Seitenflächen 181 des Trägers 18 auch für Halbleiterchips gemäß den zweiten bis zehnten Ausführungsbeispielen geeignet. Ein derartiger Träger mit schräg stehenden Seitenflächen ist beispielsweise mittels Sägens des Trägers von der dem Halbleiterkörper 10 abgewandten Seite her herstellbar.

Ein zwölftes Ausführungsbeispiel für einen erfindungsgemäßen Halbleiterchip 1 ist in der Figur 12 anhand einer schematischen Schnittansicht gezeigt. Der Halbleiterchip gemäß dem zwölften Ausführungsbeispiel entspricht im Wesentlichen dem in Zusammenhang mit den Figuren 1A und 1B beschriebenen ersten Ausführungsbeispiel.

Im Unterschied zum ersten Ausführungsbeispiel ist die n-leitende Halbleiterschicht 13 der Halbleiterschichtenfolge 10 von der dem Träger abgewandten Seite des Halbleiterkörpers 10 her freigelegt. In dem freigelegten Bereich ist die weitere Kontaktschicht 42 angeordnet. Im Unterschied zum ersten Ausführungsbeispiel sind hier die Kontaktschicht 41 und die weitere Kontaktschicht 42 auf derselben Seite des Trägers 18 angeordnet. Die Kontaktschicht 41 und die weitere Kontaktschicht 42 sind also von derselben Seite des Trägers 18 her zugänglich. Dies kann eine Kontaktierung des Halbleiterchips 1 mit externen Anschlussleitern vereinfachen. Weiterhin kann der Träger 18 in diesem Fall auch elektrisch isolierend ausgebildet sein. Der Träger kann also unabhängig von seinen elektrischen Eigenschaften gewählt werden.

Ein dreizehntes Ausführungsbeispiel für einen erfindungsgemäßen Halbleiterchip ist in Figur 13 anhand einer schematischen Schnittansicht gezeigt. Das dreizehnte Ausführungsbeispiel entspricht im Wesentlichen dem ersten Ausführungsbeispiel, wobei der Halbleiterchip 1 als Dünnfilmhalbleiterchip ausgeführt ist.

Im Unterschied zum ersten Ausführungsbeispiel ist der Halbleiterkörper 10 derart angeordnet, dass der nichtmetallische Anschlussbereich 2 zwischen der p-leitenden Halbleiterschicht 11 und dem Träger 18 angeordnet ist. Der Halbleiterkörper 10 ist mittels einer Verbindungsschicht 5 an dem Träger 18 befestigt. Die Verbindungsschicht 5 ist bevorzugt elektrisch leitfähig ausgeführt und kann beispielsweise mittels eines Lots gebildet sein. Alternativ kann die Verbindungsschicht beispielsweise einen, vorzugsweise elektrisch leitfähigen, Kleber enthalten.

Das Abscheidesubstrat für die Halbleiterschichtenfolge 10 ist vollständig entfernt und in der Figur 13 daher nicht dargestellt. Davon abweichend kann das Abscheidesubstrat auch gedünnt oder nur bereichsweise entfernt sein.

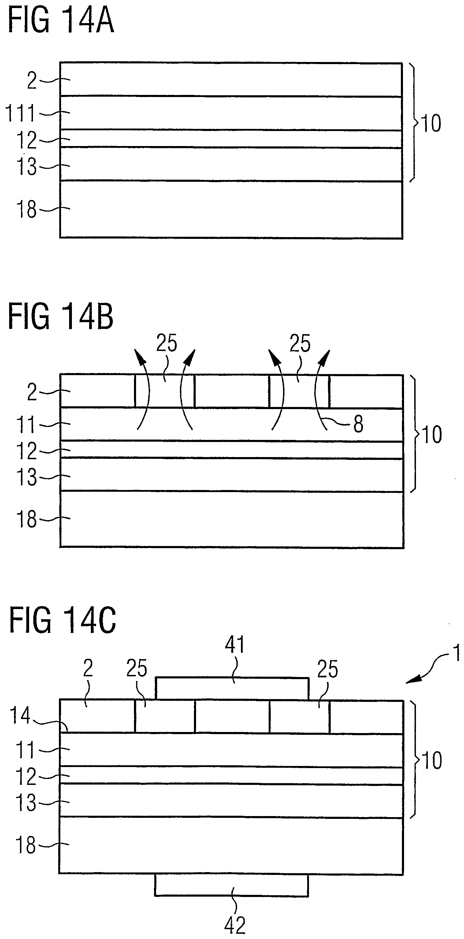

Ein erstes Ausführungsbeispiel für ein erfindungsgemäßes Verfahren zur Herstellung eines Halbleiterchips ist in den Figuren 14A bis 14C anhand von schematisch in Schnittansicht dargestellten Zwischenschritten gezeigt.

Zunächst wird ein Abscheidesubstrat 18 bereitgestellt. Auf dem Abscheidesubstrat wird die Halbleiterschichtenfolge 10 abgeschieden. Hierbei wird zunächst die n-leitende Halbleiterschicht 13 und nachfolgend der aktive Bereich 12 abgeschieden. Auf dem aktiven Bereich 12 wird eine Akzeptor-haltige Halbleiterschicht 111 abgeschieden. Nach der Abscheidung des nichtmetallischen Anschlussbereichs 2 werden bei dem in Figur 14A dargestellten Halbleiterkörper Ausnehmungen in dem nichtmetallischen Anschlussbereich 2 ausgebildet. Die Ausnehmungen werden vorzugsweise mittels eines nasschemischen oder trockenchemischen Ätzverfahrens hergestellt.

Nach dem Ausbilden der Ausnehmungen 25 erfolgt eine Aktivierung der Akzeptoren der Akzeptor-haltigen Halbleiterschicht 111. Die Aktivierung erfolgt vorzugsweise thermisch, wobei der Halbleiterkörper auf eine Temperatur zwischen 400° C und 1100° C gebracht wird. An den Akzeptor, vorzugsweise Mg, gekoppelter Wasserstoff kann während der Aktivierung von dem Akzeptor abgelöst werden und durch die Ausnehmungen 25 des nichtmetallischen Anschlussbereichs 2 seitens des nichtmetallischen Anschlussbereichs aus dem Halbleiterkörper 10 austreten. So entsteht eine p-leitende Halbleiterschicht 11.

Das Austreten des Wasserstoffs durch die Ausnehmungen ist in Figur 14B anhand der Pfeile 8 schematisch dargestellt. Nachfolgend kann der Halbleiterchip fertig gestellt werden.

Ein fertig gestellter Halbleiterchip ist in Figur 14C gezeigt. Die Kontaktschicht 41 und die weitere Kontaktschicht 42 werden vorzugsweise in einem PVD- oder einem CVD-Verfahren hergestellt. Besonders bevorzugte Verfahren sind Aufdampfen und Aufsputtern. Von dem gezeigten Ausführungsbeispiel abweichend kann die Kontaktschicht 41 auch vor der Aktivierung der Akzeptor-haltigen Halbleiterschicht 111 auf dem Halbleiterkörper aufgebracht werden. Dies ist insbesondere dann zweckmäßig, wenn nicht alle Aussparungen 25 des nichtmetallischen Anschlussbereichs 2 von der Kontaktschicht 41 bedeckt werden, sodass Wasserstoff durch die Aussparungen 25 aus dem Halbleiterkörper 10 austreten kann. Die Leitfähigkeit der Akzeptor-haltigen Halbleiterschicht 111 kann durch dieses Verfahren auf einfache Weise verbessert werden.

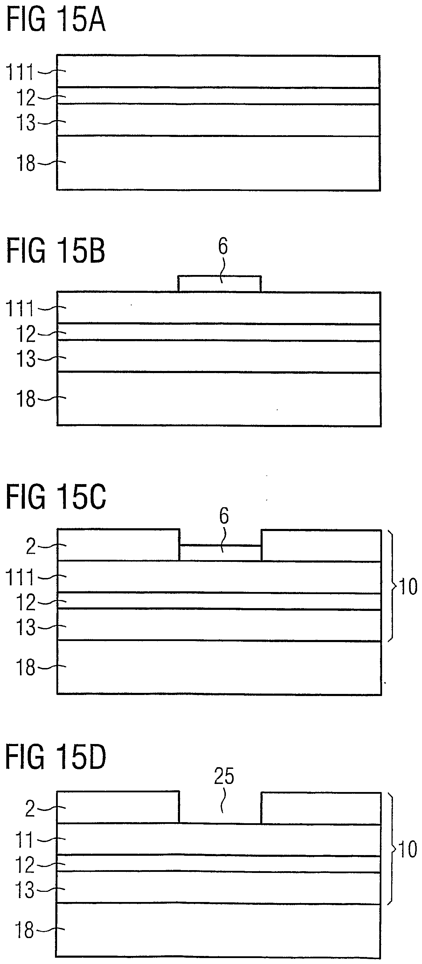

In den Figuren 15A bis 15D ist ein zweites Ausführungsbeispiel für ein erfindungsgemäßes Verfahren gezeigt. Wie im Zusammenhang mit Figur 14A beschrieben, werden zunächst eine n-leitende Halbleiterschicht 13, ein aktiver Bereich 12 und eine Akzeptor-haltige Halbleiterschicht 111 auf einem bereitgestellten Abscheidesubstrat abgeschieden (siehe Figur 15A). Im Unterschied zum ersten Ausführungsbeispiel wird zur Herstellung des nichtmetallischen Anschlussbereichs zunächst eine Hilfsschicht 6 auf der Akzeptor-haltigen Halbleiterschicht 111 aufgebracht und bereichsweise entfernt, so dass die Hilfsschicht die Akzeptor-haltige Halbleiterschicht nicht vollständig bedeckt. Dies ist in Figur 15B schematisch gezeigt. Die Hilfsschicht kann beispielsweise eine Oxidschicht oder eine Lackschicht sein, die mittels Photolithographie strukturiert wird.

Nachfolgend wird der nichtmetallische Anschlussbereich 2 auf der Akzeptor-haltigen Halbleiterschicht abgeschieden. Die Abscheidung erfolgt vorzugsweise epitaktisch, beispielsweise mittels MOCVD oder MBE. Die Akzeptor-haltige Halbleiterschicht wird also bereichsweise überwachsen. Hierbei bleibt die Hilfsschicht 6 frei von dem Halbleitermaterial für den Anschlussbereich 2. So entsteht bereits während der Abscheidung des nichtmetallischen Anschlussbereichs 2 eine Ausnehmung 25 in dem nichtmetallischen Anschlussbereich. Dies zeigt Figur 15C. Nachfolgend kann die Hilfsschicht 6 entfernt werden, was in Figur 15D gezeigt ist. Die weiteren Schritte zur Herstellung des Halbleiterchips, insbesondere das Aufbringen der Kontaktschichten sowie die Aktivierung der Akzeptoren, können wie im Zusammenhang mit dem ersten Ausführungsbeispiel beschrieben durchgeführt werden. Hierbei kann die Aktivierung der Akzeptoren in der p-leitenden Halbleiterschicht vor oder nach dem Entfernen der Hilfsschicht 6 durchgeführt werden.

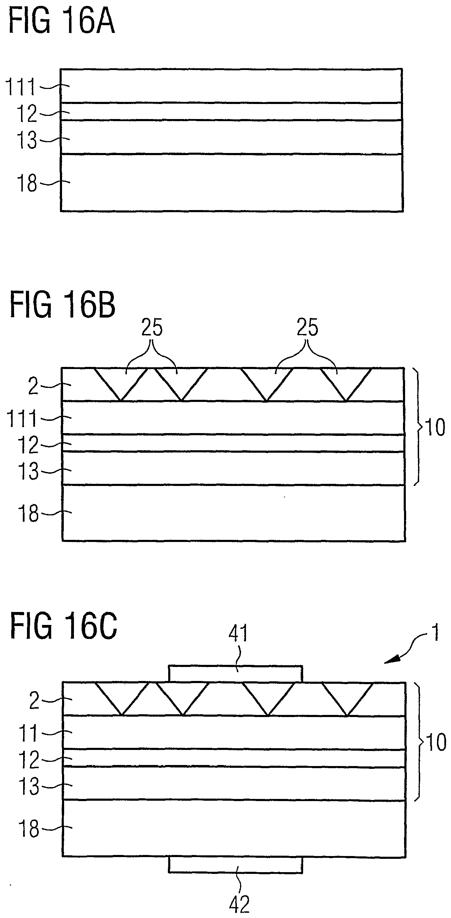

Ein drittes Ausführungsbeispiel für ein erfindungsgemäßes Verfahren ist anhand schematisch dargestellter Zwischenschritte in Schnittansicht in den Figuren 16A bis 16C gezeigt.

Wie im Zusammenhang mit Figur 14A beschrieben, werden zunächst eine n-leitende Halbleiterschicht 13, ein aktiver Bereich 12 und eine Akzeptor-haltige Halbleiterschicht 111 auf einem bereitgestellten Abscheidesubstrat abgeschieden (siehe Figur 16A).

Im Unterschied zum ersten Ausführungsbeispiel werden die Ausnehmungen in dem nichtmetallischen Anschlussbereich 2 bereits während der Abscheidung hergestellt. Der Anschlussbereich ist hierbei vorzugsweise mittels zumindest einer Halbleiterschicht gebildet. Die Abscheideparameter für den nichtmetallischen Anschlussbereich 2 werden derart gewählt, dass sich in dem nichtmetallischen Anschlussbereich während der Abscheidung Ausnehmungen in Form von Nanokanälen ausbilden. Dies ist in Figur 16B gezeigt. Auf ein Ausbilden von Ausnehmungen in dem nichtmetallischen Anschlussbereich 2 nach dessen Abscheidung kann mit Vorteil verzichtet werden.

Nachfolgend können die Akzeptoren der Akzeptor-haltigen Halbleiterschicht 111 wie im Zusammenhang mit dem ersten Ausführungsbeispiel beschrieben aktiviert werden, wobei Wasserstoff durch die Nanokanäle aus dem Halbleiterkörper 10 austreten kann. Die weiteren Schritte zur Herstellung des Halbleiterchips 1 gemäß Figur 16C, können wie im Zusammenhang mit dem ersten Ausführungsbeispiel beschrieben durchgeführt werden.

## Patentansprüche

1. Halbleiterchip (1), umfassend einen Halbleiterkörper mit einer Halbleiterschichtenfolge (10), die einen aktiven Bereich (12) und eine p-leitende Halbleiterschicht (11) aufweist, wobei
- auf einer dem aktiven Bereich (12) abgewandten Seite der p-leitenden Halbleiterschicht ein nichtmetallischer Anschlussbereich (2) angeordnet ist,
- der nichtmetallische Anschlussbereich (2) elektrisch leitend mit der p-leitenden Halbleiterschicht (11) verbunden ist,
- der nichtmetallische Anschlussbereich (2) eine Halbleiterschicht (21) aufweist, die n-dotiert oder undotiert ist,
**dadurch gekennzeichnet dass**
- der nichtmetallische Anschlussbereich (2) für Wasserstoff durchlässig ausgebildet ist, und
- der nichtmetallische Anschlussbereich (2) eine Ausnehmung (25) oder eine Mehrzahl von Ausnehmungen (25) aufweist und Wasserstoff durch die Ausnehmung beziehungsweise durch die Ausnehmungen aus der p-leitenden Halbleiterschicht (11) austreten kann, wobei sich die Ausnehmung beziehungsweise die Ausnehmungen (25) entlang einer Abscheiderichtung der Halbleiterschichtenfolge (10) durch den nichtmetallischen Anschlussbereich (2) hindurch erstrecken.

2. Halbleiterchip nach Anspruch 1,
bei dem der nichtmetallische Anschlussbereich (2) mittels eines für im aktiven Bereich (12) erzeugte Strahlung durchlässigen Materials gebildet ist.

3. Halbleiterchip nach Anspruch 1 oder 2,
bei dem die Halbleiterschicht (21) auf AlₓIn_{y}Ga_{1-x-y}N mit 0 ≤ x ≤ 1 und 0 < y ≤ 1 basiert und bei dem der nichtmetallische Anschlussbereich (2) eine weitere Halbleiterschicht (22) aufweist, die auf GaN basiert.

4. Halbleiterchip nach einem der Ansprüche 1 bis 3,
bei dem der nichtmetallische Anschlussbereich (2) mittels einer auf dem Halbleiterkörper (10) angeordneten Schicht (27) gebildet ist.

5. Halbleiterchip nach Anspruch 4,
bei dem die auf dem Halbleiterkörper (10) angeordnete Schicht (27) ein TCO-Material enthält.

6. Halbleiterchip nach einem der vorhergehenden Ansprüche, bei dem der nichtmetallische Anschlussbereich (2) mittels der Ausnehmung (25) beziehungsweise der Ausnehmungen (25) gemäß einem photonischen Kristall (26) geformt ist.

7. Halbleiterchip nach einem der vorhergehenden Ansprüche,
bei dem die Ausnehmungen (25) des nichtmetallischen Anschlussbereichs (2) als Nanokanäle (255) ausgebildet sind, wobei die Nanokanäle (255) in dem nichtmetallischen Anschlussbereich (2) eine Flächendichte von einschließlich 10⁶ cm⁻² bis einschließlich 10¹² cm⁻², bevorzugt von einschließlich 10⁸ cm⁻² bis einschließlich 10¹⁰ cm⁻², aufweisen.

8. Halbleiterchip nach einem der vorhergehenden Ansprüche, bei dem
- der nichtmetallische Anschlussbereich (2) in zumindest zwei lateral voneinander beabstandete Teilbereiche (24) geteilt ist;
- auf dem nichtmetallischen Anschlussbereich zumindest bereichsweise eine Kontaktschicht (41) angeordnet ist;
- die Kontaktschicht (41) elektrisch leitend mit dem nichtmetallischen Anschlussbereich (2) verbunden ist; und
- voneinander beabstandete Teilbereiche (24) des nichtmetallischen Anschlussbereichs (2) mittels der Kontaktschicht (41) elektrisch leitend verbunden sind.

9. Halbleiterchip nach Anspruch 8,
bei dem die p-leitende Halbleiterschicht (11) in einem in lateraler Richtung umgrenzten Bereich (15) eine geringere Leitfähigkeit aufweist als außerhalb des in lateraler Richtung umgrenzten Bereichs und bei dem der in lateraler Richtung umgrenzte Bereich (15) der p-leitenden Halbleiterschicht (11) in einem Grundriss des Halbleiterchips mit der Kontaktschicht (41) überlappt.

10. Verfahren zur Herstellung eines Halbleiterchips (1), der einen Halbleiterkörper mit einer Halbleiterschichtenfolge (10) aufweist, wobei die Halbleiterschichtenfolge (10) einen aktiven Bereich (12) und eine p-leitende Halbleiterschicht (11) umfasst, mit den Schritten:
a) Bereitstellen eines Abscheidesubstrats (18),
b) Abscheiden des aktiven Bereichs auf dem Abscheidesubstrat (18),
c) Abscheiden einer Akzeptor-haltigen Halbleiterschicht (111),
d) Ausbilden eines nichtmetallischen Anschlussbereichs, durch den Gas aus der Akzeptor-haltigen Halbleiterschicht (111) austreten kann, wobei der nichtmetallische Anschlussbereich eine Halbleiterschicht (21) aufweist, die n-dotiert oder undotiert ist, und eine Ausnehmung (25) oder eine Mehrzahl von Ausnehmungen (25) aufweist und Wasserstoff durch die Ausnehmung beziehungsweise durch die Ausnehmungen aus der p-leitenden Halbleiterschicht (11) austreten kann, wobei sich die Ausnehmung beziehungsweise die Ausnehmungen (25) entlang einer Abscheiderichtung der Halbleiterschichtenfolge (10) durch den nichtmetallischen Anschlussbereich (2) hindurch erstrecken,
e) Herstellen der p-leitenden Halbleiterschicht (11) mittels Aktivierung von Akzeptoren in der Akzeptor-haltigen Halbleiterschicht (111), und
f) Fertigstellen des Halbleiterchips (1).

11. Verfahren nach Anspruch 10,
bei dem die zumindest eine Halbleiterschicht für den nichtmetallischen Anschlussbereich (21) mittels bereichsweisen Überwachsens auf der Akzeptor-haltigen Halbleiterschicht (111) ausgebildet wird.

12. Verfahren nach Anspruch 10 oder 11,
bei dem ein Halbleiterchip (1) gemäß einem der Ansprüche 1 bis 9 hergestellt wird.

## Claims

1. A semiconductor chip (1) comprising a semiconductor body having a semiconductor layer sequence (10), the semiconductor layer sequence having an active area (12) and a p-conducting semiconductor layer (11), wherein
- on a side of the p-conducting semiconductor layer facing away from the active region (12) a non-metallic connection region (2) is arranged,
- the non-metallic connection region (2) is electrically conductively connected to the p-conducting semiconductor layer (11),
- the non-metallic connection region (2) has a semiconductor layer (21) which is n-doped or undoped,
**characterized in that**
- the non-metallic connection region (2) is designed to be permeable to hydrogen, and
- the non-metallic connection region (2) comprises a recess (25) or a plurality of recesses (25) and hydrogen can escape through the recess or through the recesses from the p-conducting semiconductor layer (11), wherein the recess or the recesses (25) extend along a deposition direction of the semiconductor layer sequence (10) through the non-metallic connection region (2).

2. Semiconductor chip according to claim 1,
wherein the non-metallic connection region (2) is formed by means of a material which is transmissive to radiation generated in the active region (12).

3. Semiconductor chip according to claim 1 or 2,
wherein the semiconductor layer (21) is based on AlₓIn_{y}Ga_{1-x-y}N with 0 ≤ x ≤ 1 und 0 < y ≤ 1, and wherein the non-metallic connection region (2) comprises a further semiconductor layer (22) based on GaN.

4. Semiconductor chip according to one of claims 1 to 3,
wherein the non-metallic connection region (2) is formed by means of a layer (27) arranged on the semiconductor body (10).

5. Semiconductor chip according to claim 4,
wherein the layer (27) arranged on the semiconductor body (10) contains a TCO material.

6. Semiconductor chip according to one of the preceding claims,
in which the non-metallic connection region (2) is shaped in accordance with a photonic crystal (26) by means of the recess (25) or the recesses (25).

7. Semiconductor chip according to one of the preceding claims,
in which the recesses (25) of the non-metallic connection region (2) are formed as nanochannels (255), wherein the nanochannels (255) in the non-metallic connection region (2) have a surface density of from 10⁶ cm⁻² inclusive to 10¹² cm⁻² inclusive, preferable of from 10⁸ cm⁻² inclusive to 10¹⁰ cm⁻² inclusive.

8. Semiconductor chip according to one of the preceding claims,
wherein
- the non-metallic connection portion (2) is divided into at least two laterally spaced apart partial regions (24);
- a contact layer (41) is at least partially arranged on the non-metallic connection region;
- the contact layer (41) is electrically conductively connected to the non-metallic connection region (2); and
- partial regions (24) of the non-metallic connection portion (2) spaced apart from each other are electrically connected by means of the contact layer (41).

9. Semiconductor chip according to claim 8,
wherein the p-conducting semiconductor layer (11) has a lower conductivity in a laterally bounded region (15) than outside the laterally bounded region and wherein the laterally bounded region (15) of the p-conducting semiconductor layer (11) overlaps in a plan view of the semiconductor chip with the contact layer (41).

10. A method for producing a semiconductor chip having a semiconductor body with a semiconductor layer sequence, the semiconductor layer sequence comprising an active region and a p-conducting semiconductor layer, comprising the steps:
a) providing a deposition substrate (18),
b) depositing the active region on the deposition substrate (18),
c) depositing an acceptor-containing semiconductor layer (111),
d) forming a non-metallic connection region through which gas can escape from the acceptor-containing semiconductor layer (111), wherein the non-metallic connection region comprises a semiconductor layer (21), which is n-doped or undoped, and a recess (25) or a plurality of recesses (25) and wherein hydrogen can escape from the p-conducting semiconductor layer (11) through the recess or through the recesses, wherein the recess or the recesses (25) extend through the non-metallic connection region (2) along a deposition direction of the semiconductor layer sequence (10),
e) producing the p-conducting semiconductor layer (11) by activating acceptors in the acceptor-containing semiconductor layer (111), and
f) finishing the semiconductor chip (1).

11. The method according to claim 10,
in which the at least one semiconductor layer for the non-metallic connection region (21) is formed by zone-wise overgrowth on the acceptor-containing semiconductor layer (111).

12. The method according to claim 10 or 11,
in which a semiconductor chip (1) according to one of claims 1 to 9 is produced.

## Revendications

1. Puce à semi-conducteur (1) comprenant un corps semi-conducteur doté d'une succession de couches semi-conductrices (10), laquelle présente une zone active (12) et une couche semi-conductrice (11) de type p,
- une zone de connexion (2) non métallique étant disposée sur un côté détourné de la zone active (12), de la couche semi-conductrice de type p,
- la zone de connexion (2) non métallique étant reliée de manière électro-conductrice à la couche semi-conductrice (11) de type p,
- la zone de connexion (2) non métallique présentant une couche semi-conductrice (21) qui est dopée n ou est non dopée, **caractérisée en ce que**
- la zone de connexion (2) non métallique est conçue pour être perméable à l'hydrogène, et
- la zone de connexion (2) non métallique présente un évidement (25) ou une pluralité d'évidements (25) et **en ce que** de l'hydrogène peut s'échapper de la couche semi-conductrice (11) de type p à travers l'évidement, respectivement les évidements, l'évidement, respectivement les évidements (25), s'étendant le long d'une direction de dépôt de la succession de couches semi-conductrices (10) en traversant la zone de connexion (2) non métallique.

2. Puce à semi-conducteur selon la revendication 1,
dans laquelle la zone de connexion (2) non métallique est formée au moyen d'un matériau perméable à un rayonnement généré dans la zone active (12).

3. Puce à semi-conducteur selon la revendication 1 ou 2, dans laquelle la couche semi-conductrice (21) est basée sur AlₓIn_{y}Ga_{1-x-y}N, avec 0 ≤ x ≤ 1 et 0 < y ≤ 1, et dans laquelle la zone de connexion (2) non métallique présente une couche semi-conductrice supplémentaire (22) qui est basée sur GaN.

4. Puce à semi-conducteur selon l'une quelconque des revendications 1 à 3,
dans laquelle la zone de connexion (2) non métallique est formée au moyen d'une couche (27) disposée sur le corps semi-conducteur (10).

5. Puce à semi-conducteur selon la revendication 4,
dans laquelle la couche (27) disposée sur le corps semi-conducteur (10) contient un matériau TCO.

6. Puce à semi-conducteur selon l'une quelconque des revendications précédentes,
dans laquelle la zone de connexion (2) non métallique est formée au moyen de l'évidement (25), respectivement des évidements (25), selon un cristal (26) photonique.

7. Puce à semi-conducteur selon l'une quelconque des revendications précédentes,
dans laquelle les évidements (25) de la zone de connexion (2) non métallique sont réalisés comme nano canaux (255), les nano canaux (255) présentant dans la zone de connexion (2) non métallique une densité superficielle de, y compris, 10⁶ cm⁻² à, y compris, 10¹² cm⁻², de préférence de, y compris, 10⁸ cm⁻² à, y compris, 10¹⁰ cm⁻².

8. Puce à semi-conducteur selon l'une quelconque des revendications précédentes,
dans laquelle
- la zone de connexion (2) non métallique est divisée en au moins deux zones partielles (24) latéralement distancées les unes des autres ;
- une couche de contact (41) est disposée au moins par sections sur la zone de connexion non métallique ;
- la couche de contact (41) est reliée de manière électroconductrice à la zone de connexion (2) non métallique ; et
- des zones partielles (24) de la zone de connexion (2) non métallique, distancées les unes des autres, sont reliées de manière électroconductrice au moyen de la couche de contact (41).

9. Puce à semi-conducteur selon la revendication 8,
dans laquelle la couche semi-conductrice (11) de type p présente dans une zone (15) délimitée en direction latérale une conductivité plus faible qu'à l'extérieur de la zone délimitée en direction latérale, et dans laquelle la zone (15) délimitée en direction latérale de la couche semi-conductrice (11) de type p chevauche avec la couche de contact (41) dans une projection horizontale de la puce à semi-conducteur.

10. Procédé de fabrication d'une puce à semi-conducteur (1) qui présente un corps semi-conducteur doté d'une succession de couches semi-conductrices (10), la succession de couches semi-conductrices comprenant une zone active (12) et une couche semi-conductrice (11) de type p, comprenant les étapes :
a) fourniture d'un substrat de dépôt (18),
b) déposition de la zone active sur le substrat de dépôt (18),
c) déposition d'une couche semi-conductrice (111) contenant des accepteurs,
d) réalisation d'une zone de connexion non métallique à travers laquelle du gaz peut s'échapper de la couche semi-conductrice (111) contenant des accepteurs, la zone de connexion non métallique présentant une couche semi-conductrice (22) qui est dopée n ou est non dopée, et un évidement (25) ou une pluralité d'évidements (25), et de l'hydrogène pouvant s'échapper de la couche semi-conductrice (11) de type p à travers l'évidement, respectivement les évidements, l'évidement, respectivement les évidements (25), s'étendant le long d'une direction de dépôt de la succession de couches semi-conductrices (10) en traversant la zone de connexion (2) non métallique,
e) création de la couche semi-conductrice (11) de type p par activation d'accepteurs dans la couche semi-conductrice (111) contenant des accepteurs, et
f) compléter la puce à semi-conducteur (1).

11. Procédé selon la revendication 10,
dans lequel l'au moins une couche semi-conductrice est réalisée pour la zone de connexion (21) non métallique par croissance, par sections, sur la couche semi-conductrice (111) contenant des accepteurs.

12. Procédé selon la revendication 10 ou 11,
dans lequel une puce à semi-conducteur (1) est fabriquée selon l'une quelconque des revendications 1 à 9.
